# FASCICULE DE BREVET EUROPEEN

(11) **EP 2 603 448 B1**
(45) Date de publication et mention de la délivrance du brevet: **06.08.2014**
(21) Numéro de dépôt: 11741601.6
(22) Date de dépôt: 11.08.2011
(51) Int. Cl.: B81B 3/00

(54) **MICROSYSTEMES ELECTROMECANIQUES A GAPS D'AIR**
MIKROELEKTROMECHANISCHES SYSTEM MIT EINEM LUFTSPALT
MICROELECTROMECHANICAL SYSTEM WITH AIR GAP

(30) Priorité: 11.08.2010 FR 1056549
(43) Date de publication de la demande: 19.06.2013
(73) Titulaire: Université de Limoges, 87000 Limoges (FR); Centre National de la Recherche Scientifique (CNRS), 75016 Paris (FR)
(72) Inventeur: BLONDY, Pierre, F-87000 Limoges (FR); COURREGES, Stanis, F-87100 Limoges (FR); POTHIER, Arnaud, F-87920 Condat sur Vienne (FR); ORLIANGES, Jean-Christophe, F-19170 Bugeat (FR)
(74) Mandataire: Regimbeau
(86) Numéro de dépôt international: PCT/EP2011/063856
(87) Numéro de publication internationale: WO 2012/020095

(56) Documents cités:
- US-A1- 2003 058 069
- US-A1- 2003 227 361
- US-A1- 2009 021 884

## Description

### DOMAINE TECHNIQUE GENERAL

La présente demande concerne le domaine des microsystèmes électromécaniques.

### ETAT DE L'ART

Les microsystèmes électromécaniques (MEMS) sont notamment utilisés dans la conception de circuits ayant des fonctions de commutation ou de circuits reconfigurables (agiles). Les microsystèmes électromécaniques ont par exemple une fonction d'actionneur.

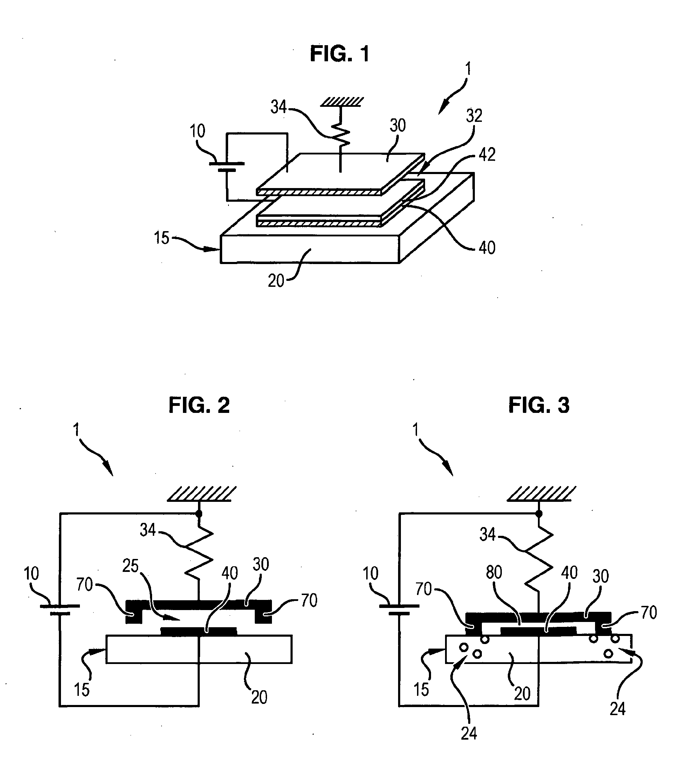

La figure 1 présente un microsystème électromécanique 1 selon l'état de la technique, plus spécifiquement un actionneur électrostatique à plaques parallèles.

Ce microsystème électromécanique 1 comprend une base 15 comprenant un substrat 20, une électrode de substrat 40 disposée sur ledit substrat 20, et une poutre mobile 30 placée en regard de l'électrode de substrat 40.

Une couche de diélectrique 42 est interposée entre l'électrode de substrat 40 et la poutre mobile 30 en ménageant par ailleurs un intervalle ou gap électrostatique 32. Ce gap a typiquement une épaisseur de quelques micromètres lorsque le microsystème est en position de repos. La couche de diélectrique 42 peut être placée sur l'électrode de substrat 40 ou sur la poutre mobile 30.

Selon le mode de réalisation illustré sur la figure 1, la couche de diélectrique 42 est placée sur l'électrode de substrat 40 et la poutre mobile 30 est séparée de la couche de diélectrique 42 par le gap électrostatique 32.

La poutre mobile 30 est illustrée comme étant maintenue par un ressort de suspension 34 qui illustre la capacité de déformation élastique de la poutre mobile 30.

Un générateur de tension 10 est relié sur commande à la poutre 30 et à l'électrode de substrat 40, de manière à pouvoir appliquer une différence de potentiel entre la poutre mobile 30 et l'électrode de substrat 40.

Lors de l'application d'une différence de potentiel entre la poutre mobile 30 et l'électrode de substrat 40, la poutre mobile 30 se déplace, et vient au contact de la couche de diélectrique 42, sous l'effet de la force électrostatique générée.

Le contact entre la poutre mobile 30 et l'électrode de substrat 40 est alors réalisé via la fine couche de diélectrique 42 recouvrant la poutre mobile 30 ou l'électrode de substrat 40.

Plusieurs variantes sont possibles.

La poutre mobile 30 peut par exemple être fixe à une extrémité et libre à une autre, l'extrémité libre venant alors au contact de la couche de diélectrique 42 lors de l'application d'une différence de potentiel entre la poutre mobile 30 et l'électrode de substrat 40.

La poutre mobile 30 peut également être fixée à ses extrémités sur la base 15, mais posséder une souplesse intrinsèque de sorte que la déformation de la poutre mobile 30, lors de l'application d'une différence de potentiel, entraîne le contact du centre de la poutre mobile 30 avec la base 15.

Ces composants présentent toutefois des défaillances rapides et non réversibles entraînant une durée de vie et une fiabilité limitées, typiquement de l'ordre de quelques minutes, lorsque la poutre mobile 30 est maintenue constamment à l'état déformé et soumise à une alimentation en tension unipolaire.

Cet inconvénient est provoqué par une injection de charges dans la base 15 lors du contact entre la poutre 30 et la base 15.

En effet, l'injection de charges provoque l'apparition d'une tension de charge, qui, selon le type de charge, s'oppose ou se superpose à la différence de potentiel appliquée entre la poutre 30 et l'électrode de substrat 40.

Au fur et à mesure de l'injection de charges dans la base 15, ou plus particulièrement dans la couche de diélectrique 42, et donc au fur et à mesure que des charges s'accumulent, cette tension de charge augmente, jusqu'à bloquer l'actionneur. Il en résulte une défaillance rapide de l'actionneur, par exemple de l'ordre de quelques dizaines de minutes, très souvent non réversible sur des laps de temps courts.

Plusieurs solutions ont été proposées afin de réduire l'injection de charges ou d'évacuer les charges injectées dans la couche de diélectrique, mais ces solutions ne permettent pas d'obtenir une durée de vie suffisante, en particulier pour des températures supérieures à 25°C.

Les figures 2 et 3 présentent, respectivement en position de repos et en position activée, un microsystème électromécanique 1 dans lequel la couche de diélectrique 42 a été supprimée. Ce microsystème électromécanique 1 est muni de butées mécaniques 70 liées à la périphérie de la poutre 30.

Les butées mécaniques 70 peuvent être fabriquées à partir de métal, semi-métal, semi-conducteur, ou tout autre matériau adapté.

On retrouve sur les figures 2 et 3 un microsystème électromécanique 1 qui comprend une base 15 comprenant un substrat 20, une électrode de substrat 40 fixe disposée sur le substrat 20 et une poutre 30 mobile en regard de l'électrode de substrat 40.

Le substrat peut par exemple être réalisé en Silicium, ou tout autre matériau adapté.

De la même manière que pour la figure 1, la poutre 30 est illustrée comme étant liée à un ressort de suspension 34 qui illustre la capacité de déformation élastique de la poutre mobile 30. La poutre 30 a une forme adaptée pour définir un espace interne 25 entre ledit substrat 20 et la poutre 30.

L'électrode de substrat 40 est disposée sur le substrat 20, sensiblement au milieu dudit espace interne 25.

Un générateur 10 est relié à la poutre 30 et à l'électrode de substrat 40, de manière à appliquer sous commande une différence de potentiel entre la poutre 30 et l'électrode de substrat 40.

La figure 2 présente le microsystème électromécanique 1 en position de repos, c'est-à dire lorsqu'aucune différence de potentiel n'est appliquée entre la poutre 30 et l'électrode de substrat 40.

Il n'y a alors pas de contact entre la poutre 30 et le substrat 20, ou entre la poutre 30 et l'électrode de substrat 40. La poutre 30 est maintenue espacée du substrat 20 et de l'électrode de substrat 40 par le ressort de suspension 34, qui représente physiquement la rigidité de la poutre 30.

La figure 3 présente le microsystème électromécanique 1 en position d'activation, où une différence de potentiel est appliquée entre la poutre 30 et l'électrode de substrat 40.

En état d'activation, la différence de potentiel appliquée entre la poutre 30 et l'électrode de substrat 40 entraine une mise en contact des butées 70 et du substrat 20. Les butées 70 maintiennent une lame d'air 80 entre la poutre 30 et l'électrode de substrat 40.

Ainsi, il n'y a pas de contact entre la poutre 30 et l'électrode de substrat 40. La lame d'air 80 joue le rôle d'isolant électrique entre la poutre 30 et l'électrode de substrat 40.

Par exemple, cette lame d'air 80 peut avoir une valeur de l'ordre de 0,1 µm à 2 µm. Cette valeur résulte de la géométrie, du placement et de la hauteur des butées 70.

L'épaisseur de la lame d'air 80 peut varier pour obtenir différentes valeurs de capacité.

L'absence de contact entre la poutre 30 et l'électrode de substrat 40 grâce à la lame d'air 80, permet d'une part d'éviter un court circuit électrique, et d'autre part d'augmenter la durée de vie de ces éléments.

En effet, dans les modes de réalisation conventionnels dans lesquels un matériau isolant est situé entre la poutre 30 et l'électrode 40, on observe un phénomène de piégeage des charges électriques dans le matériau isolant 42 lors de l'actionnement du microsystème électromécanique 1 tel que présenté sur la figure 1.

Dans le mode de réalisation connu représenté sur les figures 2 et 3, l'absence de ce matériau isolant 42 prévient cette accumulation de charges dans ledit matériau isolant 42.

Toutefois, des charges 24, représentées schématiquement sur la figure 3, s'accumulent dans le substrat 20 de la base 15, au niveau d'une surface limitée, ce qui peut résulter en une défaillance du microsystème électromécanique 1.

Ce phénomène d'injection de charges et ses conséquences négatives sur la durée de vie des microsystèmes électromécaniques constituent un verrou technologique majeur pour l'utilisation de ces composants.

### PRESENTATION DE L'INVENTION

La présente invention remédie à ces inconvénients, et propose un microsystème électromécanique comprenant :
- une base comprenant un substrat et une électrode de substrat fixée au substrat,
- une poutre mobile suspendue au-dessus du substrat,
- un générateur de tension, relié par une première borne à la poutre, et par une seconde borne à l'électrode de substrat, adapté pour générer une différence de potentiel entre la poutre et l'électrode de substrat, et
- au moins une butée mécanique liée à la poutre et adaptée pour venir au contact de la base lors de l'application d'une différence de potentiel entre la poutre et l'électrode de substrat en définissant une lame d'air entre la poutre et l'électrode de substrat,
ledit microsystème électromécanique étant caractérisé en ce qu'il comprend en outre un élément de blocage de charges électriques disposé sur le substrat, en regard de la au moins une butée mécanique, et relié électriquement à la poutre.

Selon une autre caractéristique avantageuse, ledit élément de blocage de charges électriques est constitué par au moins un plot.

Selon une autre caractéristique avantageuse, ledit élément de blocage est constitué par une couche de matériau dont la résistivité électrique est comprise entre 100 MOhms.carré et 10 kOhms.carré.

Selon une variante de ce mode de réalisation particulier, au moins un plot métallique est disposé sur ladite couche de matériau, en regard d'une butée mécanique de la poutre.

Selon encore une variante, ledit matériau constituant l'élément de blocage est un alliage de Silicium Chrome, du Carbone à structure diamant, du Silicium implanté, ou un oxyde conducteur.

Selon encore un autre mode de réalisation particulier du microsystème électromécanique conforme à la présente invention, ledit élément de blocage comprend au moins un plot métallique relié à une base électriquement conductrice disposée sur le substrat et reliée à la poutre mobile, ladite base électriquement conductrice étant surmontée d'une couche électriquement résistive, sur laquelle est disposée l'électrode de substrat.

Selon une variante, ledit substrat est réalisé en matériau parmi au moins un des matériaux suivants : céramique, saphir, quartz, silice fondue, substrats cristallins, semi-conducteurs, polymères.

Selon un mode de réalisation particulier, ladite butée est adaptée pour maintenir une épaisseur d'air entre la poutre et l'électrode de substrat comprise entre 0.1 et 2 µm.

Un tel microsystème électromécanique présente des performances supérieures à celles des microsystèmes électromécaniques capacitifs actuels, ainsi qu'un fort accroissement de la durée de vie et de sa fiabilité.

### PRESENTATION DES FIGURES

D'autres caractéristiques, buts et avantages de l'invention ressortiront de la description qui suit, qui est purement illustrative et non limitative, et qui doit être lue en regard des dessins annexés, sur lesquels :
- La figure 1 précédemment décrite présente un microsystème électromécanique selon l'état de l'art.
- Les figures 2 et 3 précédemment décrites présentent un microsystème électromécanique selon l'état de l'art muni d'une ou plusieurs butées mécaniques.

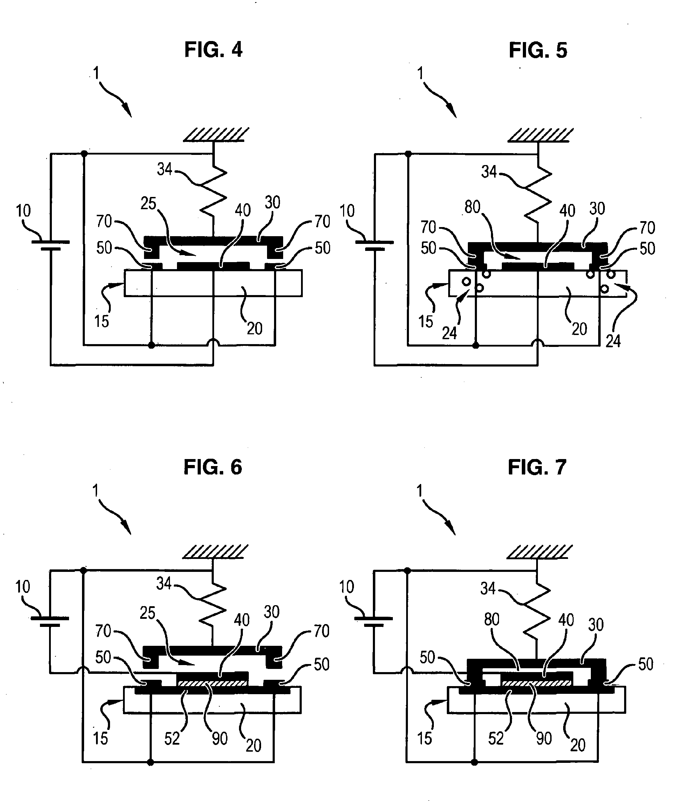

- Les figures 4 et 5 présentent un microsystème électromécanique selon un mode de réalisation particulier de l'invention.
- Les figures 6 et 7 présentent un autre mode de réalisation particulier du microsystème électromécanique selon l'invention.

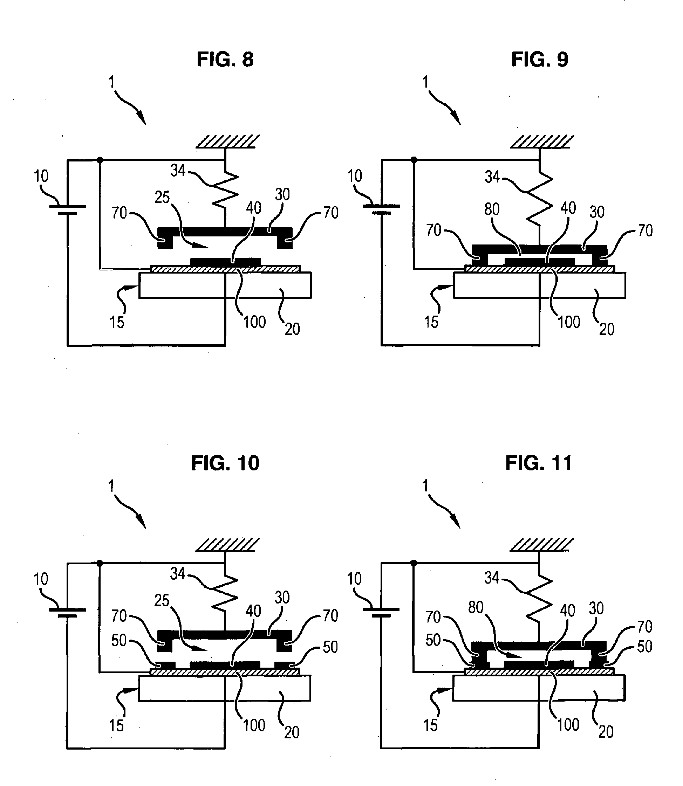

- Les figures 8 et 9 présentent un autre mode de réalisation de microsystème électromécanique selon l'invention.
- Les figures 10 et 11 présentent un autre mode de réalisation de microsystème électromécanique selon l'invention.

Dans l'ensemble des figures, les éléments similaires sont désignés par des références identiques.

### DESCRIPTION DETAILLEE

Les figures 4 et 5 présentent un mode de réalisation particulier de microsystème électromécanique 1 selon l'invention, respectivement en état de repos et en état d'activation.

Ce microsystème électromécanique 1 comprend une poutre mobile 30 et une base 15 comprenant un substrat 20 et une électrode de substrat 40 fixe disposée sur le substrat 20.

Le substrat 20 est typiquement réalisé en Silicium, ou tout autre matériau adapté, typiquement en matériau de type céramique, saphir, quartz, silice fondue, autres substrats cristallins, semi-conducteurs, polymères, ou tout autre matériau adapté.

La poutre mobile 30 munie de butées 70, est disposée au dessus du substrat 20, et est illustrée comme étant maintenue par un ressort de suspension 34 qui illustre la capacité de déformation élastique de la poutre mobile 30.

La poutre mobile 30 est par exemple réalisée en métal, tel que de l'Or, Alliage d'Or, Aluminium, Alliage d'Aluminium ou tout autre métal adapté, ou semi-conducteur, tel que du polysilicium, du silicium monocristallin, etc. Elle a une forme adaptée pour définir un espace interne 25 entre ledit substrat 20 et la poutre 30.

L'électrode de substrat 40 est disposée sur le substrat 20, sensiblement au milieu dudit espace interne 25. L'électrode de substrat 40 est typiquement fabriquée à partir de métal, semi-métal, semi-conducteur, ou tout autre matériau adapté.

Un générateur 10 est relié à la poutre 30 et à l'électrode de substrat 40, de manière à pouvoir appliquer une différence de potentiel entre la poutre 30 et l'électrode de substrat 40.

Des plots 50 typiquement réalisés en matériau métallique, semi-métal, semi-conducteur ou tout autre matériau adapté, sont disposés sur le substrat 20, en regard des butées 70 de la poutre 30. Les plots 50 sont reliés électriquement à la borne du générateur 10 reliée à la poutre 30, par exemple à la masse du générateur 10. Les plots 50 sont donc électriquement connectés à la poutre 30, et sont au même potentiel que cette dernière de manière à ne pas provoquer de court-circuit électrique.

Les plots 50 ont un rôle que l'on qualifie d'élément de blocage de charges, c'est-à-dire qu'ils bloquent l'injection de charges électriques lorsque le dispositif est activé.

En effet, en état d'activation, le contact entre les plots 50 et les butées 70 de la poutre 30 permet de bloquer l'injection de charges dans le substrat 20 dans la mesure où les plots 50 et la poutre 30 sont reliés électriquement et sont au même potentiel.

Les figures 6 et 7 présentent un autre mode de réalisation particulier du microsystème électromécanique 1 tel que présenté par les figures 4 et 5, dans lequel la base 15 comprend en outre une base électriquement conductrice 52 adjacente au substrat 20 et une couche électriquement isolante 90 superposée à la base 52.

Dans ce mode de réalisation, les plots 50 sont placés sur la base 52 et sont ainsi reliés au générateur 10 par l'intermédiaire de la base conductrice 52 commune aux plots 50, sur laquelle est disposée la couche isolante 90. L'électrode de substrat 40 est quant à elle placée sur la couche isolante 90, ce qui permet ainsi d'isoler l'électrode de substrat 40 des plots 50.

La couche isolante 90 est typiquement réalisée à partir d'une évaporation ou une pulvérisation d'un matériau ou d'un mélange de plusieurs matériaux, ou encore par dépôt chimique en phase vapeur assisté par plasma et autres techniques de dépôt d'isolant.

La figure 7 représente le microsystème électromécanique 1 en état d'activation, et illustre la superposition des éléments, à savoir respectivement :
- la poutre 30 ;
- la lame d'air 80 ;
- l'électrode de substrat 40 ;
- la couche isolante 90 ;
- la base conductrice 52 et les plots 50 ;
- le substrat 20.

Par rapport au mode de réalisation représenté sur les figures 4 et 5, ce mode de réalisation permet d'améliorer le captage et l'évacuation des charges électriques, grâce à la base conductrice 52 qui constitue une surface de captage des charges importante.

C'est ici l'ensemble constitué par les plots 50 et la base conductrice 52 qui joue le rôle d'élément de blocage de charges.

Les figures 8 et 9 présentent un autre mode de réalisation du microsystème électromécanique 1 selon l'invention.

Dans ce mode de réalisation, le microsystème électromécanique 1 comprend:
- une poutre 30 comprenant des butées mécaniques 70 ;
- une lame d'air 80;
- une électrode de substrat 40;
- une couche fortement résistive 100 ; et
- un substrat 20.

La couche fortement résistive 100, qui est disposée directement sur le substrat 20, est reliée à la borne du générateur 10 qui est reliée à la poutre 30. La poutre 30 et la couche fortement résistive 100 sont donc électriquement reliées.

Préférentiellement, le matériau utilisé pour la réalisation de la couche fortement résistive 100 a une résistivité comprise entre 100 MOhms.carré et 10 kOhms.carré. Elle est formée typiquement d'un alliage de Silicium Chrome (SiCr), du Carbone à structure diamant (DLC), du Silicium implanté, ou d'un oxyde conducteur.

Plusieurs modes de réalisation sont possibles pour le dépôt de cette couche fortement résistive 100, notamment par ablation laser, dépôt chimique en phase vapeur assisté par plasma ou toute autre méthode adaptée.

Ce mode de réalisation est notamment intéressant en raison de la simplicité de la structure de microsystème électromécanique 1 qui en résulte, qui peut ainsi être fabriqué facilement.

En état d'activation, la poutre 30 vient au contact de la couche fortement résistive 100, au niveau des butées 70. Le fait que la poutre 30 et la couche fortement résistive 100 soient électriquement connectées permet de bloquer l'injection de charges.

La couche fortement résistive 100 joue le rôle d'élément de blocage de charges électriques. Elle permet en effet de bloquer l'injection de charges lors de l'activation du dispositif dans la mesure où la couche fortement résistive 100 et la poutre 30 sont au même potentiel.

De plus, le fait de disposer la couche fortement résistive 100 sur le substrat 20 permet d'en ajuster très finement les caractéristiques, ce qui permet de préserver les performances électriques des microsystèmes.

Les figures 10 et 11 présentent, respectivement en état de repos et en état d'activation, un autre mode de réalisation du microsystème électromécanique 1 présenté sur les figures 8 et 9.

Ce mode de réalisation reprend la structure présentée sur les figures 8 et 9, auquel des plots 50 disposés en regard des butées mécaniques 70 de la poutre 30, sont ajoutés à la base 15 sur la couche fortement résistive 100.

La liaison entre la poutre 30 et la couche fortement résistive 100, lors de l'activation, se fait par l'intermédiaire des plots 50. C'est donc l'ensemble constitué par les plots 50 et la couche fortement résistive 100 qui joue le rôle.d'élément de blocage de charges électriques.

Le fait de disposer de plots 50 pour assurer le contact permet d'utiliser un matériau spécifique autre que celui de la couche résistive 100, et offre donc un degré de liberté supplémentaire.

Ces plots 50 peuvent par exemple être réalisés dans un matériau ayant un coefficient de frottement bas, typiquement un matériau choisi dans la famille des platine, tel que le Rhodium, Ruthénium, Platine, etc... ou autres matériaux adaptés.

L'invention propose donc de bloquer l'injection de charges électriques lorsque le dispositif est en état d'activation par l'ajout d'un d'élément de blocage disposé en regard des butées mécaniques 70 de la poutre 30, et connecté électriquement à la poutre 30.

Cet d'élément de blocage peut être réalisé selon plusieurs modes de réalisations particuliers. Ces modes de réalisation font notamment intervenir des plots 50, une couche de matériau fortement résistif 100, une base conductrice 52 et une couche isolante 90, ces éléments pouvant être pris individuellement ou en combinaison tel que décrit précédemment.

Limiter fortement voire empêcher le chargement diélectrique entre la poutre 30 et la base 15, ou plus particulièrement entre la poutre 30 et le substrat 20, permet d'augmenter de manière très importante la durée de vie des composants. On passe ainsi d'une durée de vie des microsystèmes électromécaniques de l'ordre de quelques minutes ou dizaines de minutes à une durée de vie de l'ordre de plusieurs mois en fonctionnement continu en état activé.

Les microsystèmes électromécaniques selon l'invention démontrent également une forte stabilité de performance sur un grand nombre de commutations lors de tests.

## Revendications

1. Microsystème électromécanique (1) comprenant :
- une base (15) comprenant un substrat (20) et une électrode de substrat (40) fixée au substrat,
- une poutre mobile (30) suspendue au-dessus du substrat (20),
- un générateur de tension (10), relié par une première borne à la poutre (30), et par une seconde borne à l'électrode de substrat (40), adapté pour générer une différence de potentiel entre la poutre (30) et l'électrode de substrat (40), et
- au moins une butée mécanique (70) liée à la poutre et adaptée pour venir au contact de la base (15) lors de l'application d'une différence de potentiel entre la poutre (30) et l'électrode de substrat (40) en définissant une lame d'air (80) entre la poutre (30) et l'électrode de substrat (40),
ledit microsystème électromécanique étant **caractérisé en ce qu'**il comprend en outre un élément de blocage de charges électriques (50, 52, 100) disposé sur le substrat (20), en regard de la au moins une butée mécanique (70), et relié électriquement à la poutre (30).

2. Microsystème électromécanique selon la revendication 1, **caractérisé en ce que** ledit élément de blocage de charges électriques est constitué par au moins un plot (50) placé en regard d'une butée mécanique (70) de la poutre (30).

3. Microsystème électromécanique selon la revendication 1, **caractérisé en ce que** ledit élément de blocage de charges électriques est constitué par une couche (100) de matériau dont la résistivité électrique est comprise entre 100 MOhms.carré et 10 kOhms.carré.

4. Microsystème électromécanique selon la revendication 3, **caractérisé en ce qu'**au moins un plot métallique (50) est disposé sur ladite couche de matériau (100), en regard d'une butée mécanique de la poutre (30).

5. Microsystème électromécanique selon l'une des revendications 3 ou 4, **caractérisé en ce que** ledit matériau constituant l'élément de blocage de charges électriques (100) est un alliage de Silicium Chrome, du Carbone à structure diamant, du Silicium implanté, ou un oxyde conducteur.

6. Microsystème électromécanique selon la revendication 1, **caractérisé en ce que** ledit élément de blocage de charges électriques comprend au moins un plot métallique (50) relié à une base conductrice disposée sur le substrat et reliée à la poutre mobile (30), ladite base conductrice étant surmontée d'une couche électriquement isolante (90), sur laquelle est disposée l'électrode de substrat (40).

7. Microsystème électromécanique selon l'une des revendications précédentes, **caractérisé en ce que** ledit substrat (20) est réalisé en matériau parmi au moins un des matériaux suivants : céramique, saphir, quartz, silice fondue, substrats cristallins, semi-conducteurs, polymères.

8. Microsystème électromécanique selon l'une des revendications précédentes, **caractérisé en ce que** la poutre mobile (30) est réalisée en métal, tel que de l'Or, Alliage d'Or, Aluminium, Alliage d'Aluminium ou semi-conducteur, tel que du polysilicium ou du silicium monocristallin.

9. Microsystème électromécanique selon l'une des revendications précédentes, **caractérisé en ce que** ledit élément de blocage de charges électriques comprend au moins un plot (50) réalisé en matériau métallique, de préférence choisi dans la famille des platine, tel que le Rhodium, Ruthénium, Platine, en semi-métal ou en semi-conducteur.

10. Microsystème électromécanique capacitif selon l'une des revendications précédentes, **caractérisé en ce que** ladite butée (70) est adaptée pour maintenir une épaisseur d'air (80) entre la poutre (30) et l'électrode de substrat (40) comprise entre 0.1 et 2 µm.

## Patentansprüche

1. Mikroelektromechanisches System (1), enthaltend:
- eine Basis (15) mit einem Substrat (20) und einer an das Substrat (40) befestigten Substratelektrode (40),
- einen über dem Substrat (20) hängenden beweglichen Träger (30),
- einen Spannungsgenerator (10), der über einen ersten Anschluss mit dem Träger (30) und über einen zweiten Anschluss mit der Substratelektrode (40) verbunden ist und dazu geeignet ist, eine Spannungsdifferenz zwischen dem Träger (30) und der Substratelektrode (40) zu erzeugen, und
- zumindest einen mechanischen Anschlag (70), der mit dem Träger verbunden und dazu geeignet ist, beim Anlegen einer Spannungsdifferenz zwischen Träger (30) und Substratelektrode (40) mit der Basis (15) in Kontakt zu gelangen, wobei er zwischen Träger (30) und Substratelektrode (40) einen Luftspalt (80) definiert,
wobei das mikroelektromechanische System **dadurch gekennzeichnet ist, dass** es ferner ein Element zum Sperren von elektrischen Ladungen (50, 52, 100) aufweist, das dem zumindest einen mechanischen Anschlag (70) gegenüberliegend an dem Substrat (20) angeordnet ist und elektrisch mit dem Träger (30) verbunden ist.

2. Mikroelektromechanisches System nach Anspruch 1, **dadurch gekennzeichnet, dass** das Element zum Sperren von elektrischen Ladungen aus zumindest einem Kontaktstück (50) besteht, das einem mechanischen Anschlag (70) des Trägers (30) gegenüberliegend positioniert ist.

3. Mikroelektromechanisches System nach Anspruch 1, **dadurch gekennzeichnet, dass** das Element zum Sperren von elektrischen Ladungen aus einer Materialschicht (100) besteht, deren spezifischer elektrischer Widerstand zwischen 100 Mohm.Quadrat und 10 kOhm.Quadrat liegt.

4. Mikroelektromechanisches System nach Anspruch 3, **dadurch gekennzeichnet, dass** zumindest ein metallisches Kontaktstück (50) einem mechanischen Anschlag des Trägers (30) gegenüberliegend an der Materialschicht (100) angeordnet ist.

5. Mikroelektromechanisches System nach einem der Ansprüche 3 oder 4, **dadurch gekennzeichnet, dass** das Material, aus dem das Element zum Sperren von elektrischen Ladungen (100) besteht, eine Legierung aus Silizium-Chrom, Kohlenstoff mit Diamantstruktur, implantiertes Silizium oder ein leitfähiges Oxid ist.

6. Mikroelektromechanisches System nach Anspruch 1, **dadurch gekennzeichnet, dass** das Element zum Sperren von elektrischen Ladungen zumindest ein metallisches Kontaktstück (50) aufweist, das mit einer leitfähigen Basis verbunden ist, die am Substrat angeordnet und mit dem beweglichen Träger (30) verbunden ist, wobei die leitfähige Basis von einer elektrisch isolierenden Schicht (90) überragt wird, an welcher die Substratelektrode (40) angeordnet ist.

7. Mikroelektromechanisches System nach einem der vorangehenden Ansprüche, **dadurch gekennzeichnet, dass** das Substrat (20) aus einem Material aus zumindest einem der nachfolgenden Materialien hergestellt ist: Keramik, Saphir, Quarz, Quarzglas, kristalline Substrate, Halbleiter, Polymere.

8. Mikroelektromechanisches System nach einem der vorangehenden Ansprüche, **dadurch gekennzeichnet, dass** der bewegliche Träger (30) aus Metall, wie etwa Gold, Goldlegierung, Aluminium, Aluminiumlegierung oder einem Halbleiter, wie etwa Polysilizium oder monokristallines Silizium, hergestellt ist.

9. Mikroelektromechanisches System nach einem der vorangehenden Ansprüche, **dadurch gekennzeichnet, dass** das Element zum Sperren von elektrischen Ladungen zumindest ein Kontaktstück (50) aufweist, das aus metallischem Material, vorzugsweise ausgewählt aus der Platinfamilie, wie etwa Rhodium, Ruthenium, Platin, Halbmetall oder Halbleiter, herstellt ist.

10. Mikroelektromechanisches System nach einem der vorangehenden Ansprüche, **dadurch gekennzeichnet, dass** der Anschlag (70) dazu geeignet ist, zwischen dem Träger (30) und der Substratelektrode (40) einen Luftspalt (80) mit einer Dicke zwischen 0,1 und 2 µm aufrechtzuhalten.

## Claims

1. An electromechanical microsystem (1) comprising:
- a base (15) comprising a substrate (20) and a substrate electrode (40) fixed to the substrate,
- a mobile beam (30) suspended above the substrate (20),
- a voltage generator (10), connected by a first terminal to the beam (30), and by a second terminal to the substrate electrode (40), adapted to generate a difference in potential between the beam (30) and the substrate electrode (40), and
- at least one mechanical stop (70) connected to the beam and adapted to come into contact with the base (15) during application of a difference in potential between the beam (30) and the substrate electrode (40) defining an air-filled cavity (80) between the beam (30) and the substrate electrode (40),
said electromechanical microsystem being **characterised in that** it also comprises an element for blocking electrical charges (50, 52, 100) arranged on the substrate (20), opposite the at least one mechanical stop (70), and connected electrically to the beam (30).

2. The electromechanical microsystem according to claim 1, **characterised in that** said element for blocking electrical charges is constituted by at least one pin (50) placed opposite a mechanical stop (70) of the beam (30).

3. The electromechanical microsystem according to claim 1, **characterised in that** said element for blocking electrical charges is constituted by a layer (100) of material whereof the electrical resistivity is between 100 MOhms.square and 10 kOhms.square.

4. The electromechanical microsystem according to claim 3, **characterised in that** at least one metal pin (50) is arranged on said layer of material (100), opposite a mechanical stop of the beam (30).

5. The electromechanical microsystem according to one of claims 3 or 4, **characterised in that** said material constituting the element for blocking electrical charges (100) is an alloy of silicon chrome, carbon of diamond structure, implanted silicon, or a conductive oxide.

6. The electromechanical microsystem according to claim **1, characterised in that** said element for blocking electrical charges comprises at least one metal pin (50) connected to a conductive base arranged on the substrate and connected to the mobile beam (30), said conductive base being topped by an electrically insulating layer (90), on which the substrate electrode (40) is arranged.

7. The electromechanical microsystem according to one of the preceding claims, **characterised in that** said substrate (20) is made of material from at least one of the following materials: ceramic, sapphire, quartz, molten silica, crystalline substrates, semiconductors, and polymers.

8. The electromechanical microsystem according to one of the preceding claims, **characterised in that** the mobile beam (30) is made of metal such as gold, gold alloy, aluminium, aluminium or semiconductor alloy, such as polysilicon or monocrystalline silicon.

9. The electromechanical microsystem according to one of the preceding claims, **characterised in that** said element for blocking electrical charges comprises at least one pin (50) made from metallic material, preferably selected from the family of platinum, such as rhodium, ruthenium, platinum, semi-metal or semiconductor.

10. A capacitive electromechanical microsystem according to one of the preceding claims, **characterised in that** said stop (70) is adapted to maintain a thickness of air (80) between the beam (30) and the substrate electrode (40) of between 0.1 and 2 µm.
